Europäisches Patentamt

European Patent Office

Office européen des brevets

(11) Veröffentlichungsnummer : **0 397 660 B1**

# (12) EUROPÄISCHE PATENTSCHRIFT

(45) Veröffentlichungstag der Patentschrift :
**11.03.92 Patentblatt 92/11**

(51) Int. Cl.⁵ : **B23K 15/00, H01J 37/16**

(21) Anmeldenummer : **88909988.3**

(22) Anmeldetag : **25.11.88**

(86) Internationale Anmeldenummer :
**PCT/DE88/00732**

(87) Internationale Veröffentlichungsnummer :
**WO 89/05206 15.06.89 Gazette 89/13**

(54) ANLAGE ZUM ELEKTRONENSTRAHLSCHWEISSEN VON WERKSTÜCKEN.

(30) Priorität : **30.11.87 DE 3740552**

(43) Veröffentlichungstag der Anmeldung :
**22.11.90 Patentblatt 90/47**

(45) Bekanntmachung des Hinweises auf die
Patenterteilung :
**11.03.92 Patentblatt 92/11**

(84) Benannte Vertragsstaaten :
**DE FR GB**

(56) Entgegenhaltungen :
**DE-A- 1 954 715**
**DE-A- 3 019 728**
**FR-A- 1 404 827**

(73) Patentinhaber : **SIEMENS**
**AKTIENGESELLSCHAFT**
**Wittelsbacherplatz 2**
**W-8000 München 2 (DE)**

(72) Erfinder : **LAMATSCH, Hans**
**Laufer Weg 36**
**W-8501 Heroldsberg (DE)**
Erfinder : **VANEK, Dieter**
**Strassburger Strasse 3**
**W-8500 Nürnberg (DE)**

EP 0 397 660 B1

## Beschreibung

Die Erfindung bezieht sich auf eine Anlage zum Elektronenstrahlschweißen von Werkstücken, mit einem Elektronenstrahlerzeuger und wenigstens zwei Werkstückkammern, die durch ein Schieberventil im Bereich der Strahlrichtung des Elektronenstrahlerzeugers untereinander verbunden und über eine Vakuumpumpe evakuierbar sind, wobei von den Werkstückkammern eine erste Kammer und eine zweite Kammer deutlich unterschiedliche Volumina haben.

Beim Elektronenstrahlschweißen müssen systembedingt die Werkstücke in einer Vakuumkammer bearbeitet werden. Die Größe der zu verschweißenden Werkstücke bestimmt dabei die Größe der erforderlichen Vakuumkammer. Je nach Größe der Werkstücke und damit der Kammer können erhebliche Evakuierungszeiten der Kammer entstehen.

Aus der FR-A-14 04 827 ist eine Anlage zum Elektronenstrahlschweißen bekannt, bei der ein Elektronenstrahlerzeuger und mehrere Werkstückkammern vorhanden sind, die jeweils durch ein Schieberventile miteinander verbindbar sind. Dabei können in erster Ausführungsform einem in einer großen Werkstückkammer verscheibbar angeordneten Eletronenstrahlerzeuger zwei außerhalb der Kammer befindliche Werkstückhalter fakultativ zugeordnet sein, die jeweils über kleine, als Schleuse ausgebildete Kammern, welche separat evakuierbar sind, in die eigentliche Werkstückkammer zur Bearbeitung eingebracht werden. In anderer Ausführungsform ist ein stationärer Elektronenstrahlerzeuger am Umfang einer ringförmigen Kammer angeordnet, bei der über radiale Schieberventile jeweils Ringsegmente abtrennbar sind und so separate, gleich große Werkstückkammern gebildet werden. Durch Rotation der Gesamtanordnung können die einzelnen Werkstückkammern dem Elektronenstrahlerzeuger zugeordnet werden. Die Anlage nach der FR-A-14 04 827 geht bei beiden Ausführungsbeispielen davon aus, daß jeweils gleiche Schweißaufgaben ausgeführt werden und daß im wesentlichen der Beladungsvorgang durch ein Kammersystem mit Wechselschleusen optimiert werden muß.

Weiterhin ist aus der DE-A-30 19 728 eine Einrichtung zum Schleusen von Objekten für Korpuskularstrahlgeräte bekannt, die insbesondere die Verwendung von Schieberventilen zeigt.

Häufig wird in der Praxis die Forderung gestellt, daß auf einer Anlage einerseits größere Werkstücke mittlerer Stückzahl und andererseits aber auch Kleinteile mit sehr großen Stückzahlen bearbeitet werden sollen. Nachteilig ist dabei, daß bei letzteren die langen Evakuierungszeiten der für die größeren Werkstükke notwendigen großen Vakuumkammern in Kauf genommen werden müssen. Dies wirkt sich in der Praxis kostensteigernd aus und wird naturgemäß als störend empfunden.

Aufgabe der Erfindung ist es daher, eine Anlage zum Elektronenstrahlschweißen zu schaffen, mit der in kostengünstiger Weise sowohl größere Werkstücke mittlerer Stückzahl, als auch Kleinteile mit sehr großer Stückzahl bearbeitet werden können.

Die Aufgabe ist erfindungsgemäß bei einer Anlage der eingangs gennanten Art durch folgende Merkmale gelöst:

– Dem Elektronenstrahlerzeuger schließt sich die erste Kammer mit kleinem Volumen an, der die zweite Kammer mit großem Volumen folgt,
– die Vakuumpumpe ist nur an der ersten Kammer mit kleinem Volumen angekoppelt,
– beide Kammern haben separate Zugangstüren, so daß sie voneinander unabhängig mit Werkstücken beladen werden können,

wobei von den Werkstückkammern die erste Kammer mit kleinem Volumen zur schnellen Bearbeitung von relativ kleinen Werkstücken und die zweite Kammer mit großem Volumen zur Bearbeitung von relativ großen Werkstücken dient.

Das Verhältnis der Volumina der beiden Werkstückkammern liegt dabei zwischen 5 und 1000, beispielsweise bei etwa 100. Vorzugsweise sind die Zugangstüren an unterschiedlichen Seiten der beiden Werkstückkammern angeordnet. Sofern die beiden Kammern übereinander angeordnet sind, kann das Schieberventil den Boden der ersten Kammer bilden.

Ein Vorteil der erfindungsgemäßen Anlage gegenüber dem Stand der Technik ist, daß keine komplizierten Bewegungseinrichtungen für die Relativverschiebung von Werkstückkammer und Elektronenstrahlerzeuger notwendig sind.

Gemäß der Erfindung wird also eine Doppelkammeranlage vorgeschlagen, bei der direkt unterhalb des Elektronenstrahlerzeugers sich eine Kleinstkammer befindet. Diese kann gerade so groß sein, daß die Kleinteile mit sehr großen Stückzahlen durch Verwendung einer großdimensionierten Pumpanordnung mit sehr kurzen Stückzeiten bearbeitet werden können. Die Kleinstkammer besitzt unmittelbar im Kammerboden im Winkel von 90° zur Achse der Strahlrichtung des Elektronenstrahlerzeugers ein großes Schieberventil, welches im geöffneten Zustand den Zugang in eine große Vakuumkammer unterhalb der Kleinstkammer freigibt. Damit kann für den Fall, daß größere Werkstücke in der Anlage geschweißt werden sollen, das Schieberventil geöffnet werden, so daß die große Kammer durch die Kleinstkammer und das Schieberventil hindurch evakuiert werden kann, wobei die nur geringfügig verlängerten Pumpzeiten für die mittleren Stückzahlen der größeren Werkstücke wirtschaftlich vertretbar sind. Der Elektronenstrahl geht dabei zur Bearbeitung dieser Teile vom Elektronenstrahlerzeuger durch die Kleinstkammer und das Schieberventil hindurch in die große Kammer, um dort die Werkstücke zu bearbeiten.

Die Verlängerung des Strahlweges für die größeren Werkstücke ist bei der erfindungsgemäßen Anlage unwesentlich, da es im allgemeinen möglich ist, aufgrund der Form der kleineren Teile, die Kleinstkammer flach zu konstruieren. Insgesamt ergibt sich durch die neue Kammeranordnung eine verbesserte Wirtschaftlichkeit in der Praxis.

Weitere Vorteile und Einzelheiten der Erfindung ergeben sich aus der nachfolgenden Figurenbeschreibung eines Ausführungsbeispiels anhand der Zeichnung.

Es zeigen

Fig. 1 eine schematische Darstellung einer Anlage zum Elektronenstrahlschweißen, aus der das Prinzip der Erfindung deutlich wird und

Fig. 2 eine perspektivische Darstellung einer so realisierten Anlage zur Verdeutlichung spezifischer Weiterbildungen der Erfindung.

Die Figuren werden weitgehend zusammen beschrieben: In beiden Figuren ist eine Anlage für das Elektronenstrahlschweißen von Werkstücken mit 1 bezeichnet. Die Anlage beinhaltet in bekannter Weise einen Elektronenstrahlerzeuger 2 aus Elektronenkanone mit Glühkathode, von der ein Elektronenstrahl längs der Strahlrichtung I in üblicher Weise in eine zugehörige Vakuumkammer gelangt.

Die Vakuumkammer besteht nun aus einer ersten Kleinen Werkstückkammer 5, die in flacher Bauweise unmittelbar hinter dem Tubus des Elektronenstrahlerzeugers 2 angeordnet ist, und einer zweiten darunterliegenden großen Werkstückkammer 15. Beide Werkstückkammern 5 und 15 sind durch ein großdimensioniertes Schieberventil 10 verbunden, das weitgehend den gesamten Bodenbereich der ersten Werkstükkammer 5 abdeckt. Dadurch kann die erste Werkstükkammer 5 im geschlossenen Zustand des Ventils 10 als Kleinstkammer für kleine Werkstückteile dienen oder aber im geöffneten Zustand des Ventiles 10 unmittelbar in die große Werkstückkammer 15 integriert sein. In jedem Fall kann der Elektronenstrahl längs der Strahlachse I unbehindert geführt werden.

Das Verhältnis der Volumina der beiden Werkstückkammern kann entsprechend den Bedürfnissen vorgewählt werden. Im vorliegenden Beispiel ist das Volumen der großen Werkstückkammer 15 etwa 100mal größer als das der kleinen Werkstückkammer 5. Sinnvolle Werte für das Verhältnis der Volumina der beiden Kammern 5 und 15 liegen etwa zwischen 5 und 1000.

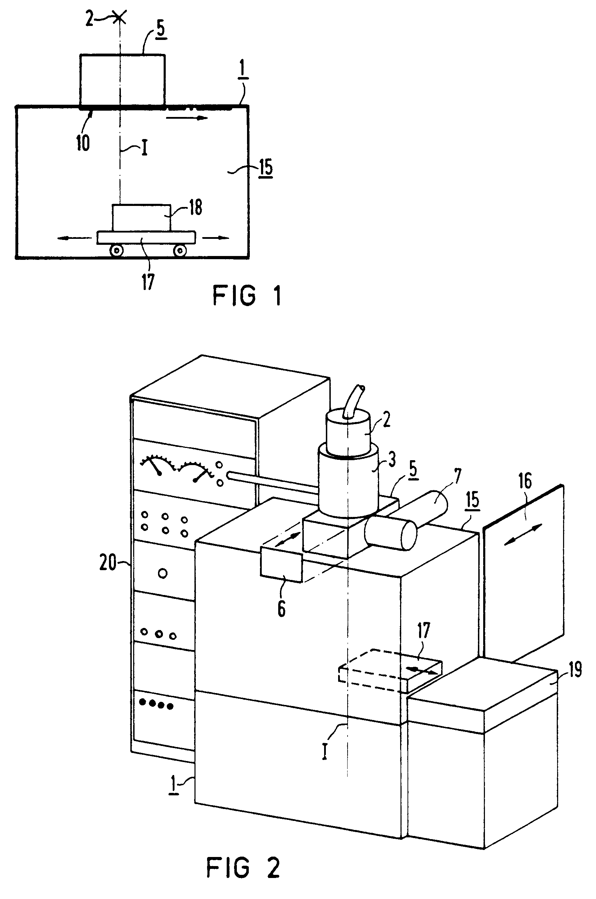

Bei der in Fig. 2 gezeigten Anlage hat es sich als besonders geeignet erwiesen, beide Werkstückkammern 5 und 15 von unterschiedlichen Seiten aus zugänglich zu machen. So hat die erste Werkstückkammer 5 eine Tür 6 in der vorderen Fläche, während die zweite Kammer 15 eine Tür 16 in ihrer seitlichen Fläche hat. Es kann dabei zweckmäßig sein, daß die Tür 6 nach vorn öffnet, während die Tür 16 als Schiebetür seitlich verschoben wird. Damit ist insbesondere ein Zugang zur großen Werkstückkammer 15 gewährleistet, in der gegebenenfalls große, voluminöse Werkstücke bearbeitet werden sollen. Hierzu ist ein Werkzeugwagen 17 für ein Werkstück 18 oder Schlitten vorhanden, der außerhalb der Werkstückkammer 15 auf einem Podest 19 beladen werden kann und kann komplett mit dem Werkstück 18 in die Kammer 15 eingeschoben wird.

Die gesamte Schweißanlage steht auf einem Grundpodest. Für die Aufnahme von Steuer- und Regeleinheiten ist ihr ein Versorgungsschrank 20 zugeordnet. Es kann eine optische Beobachtungseinrichtung vorhanden sein, mit der - gegebenenfalls über eine TV-Kamera - die einzelnen Schweißvorgänge innerhalb der Werkstückkammern 5 bzw. 15 visuell verfolgt werden können.

## Patentansprüche

1. Anlage zum Elektronenstrahlschweißen von Werkstücken, mit einem Elektronenstrahlerzeuger (2) und wenigstens zwei Werkstückkammern (5, 15), die durch ein Schieberventil (10) im Bereich der Strahlrichtung (I) des Elektronenstrahlerzeugers (2) untereinander verbunden und über eine Vakuumpumpe (7, 8) evakuierbar sind, wobei von den Werkstückkammern (5, 15) eine erste Kammer und eine zweite Kammer deutlich unterschiedliche Volumina haben, **gekennzeichnet** durch folgende Merkmale:

– Dem Elektronenstrahlerzeuger (2) schließt sich die erste Kammer (5) mit kleinem Volumen an, der die zweite Kammer (15) mit großem Volumen folgt,

– die Vakuumpumpe (7, 8) ist nur an die erste Kammer (5) mit kleinem Volumen angekoppelt,

– beide Kammern (5, 15) haben separate Zugangstüren (6, 16), so daß sie voneinander unabhängig mit Werkstücken beladen werden können,

wobei von den Werkstückkammern die erste Kammer (5) mit kleinem Volumen zur schnellen Bearbeitung von relativ kleinen Werkstücken und die zweite Kammer (15) mit großem Volumen zur Bearbeitung von relativ großen Werkstücken dient.

2. Anlage nach Anspruch 1, **dadurch gekennzeichnet**, daß das Verhältnis der Volumina der beiden Werkstückkammern (5, 15) zwischen 5 und 1000, vorzugsweise bei etwa 100, liegt.

3. Anlage nach Anspruch 1, **dadurch gekennzeichnet,** daß die Zugangstüren (6, 16) an unterschiedlichen Seiten der beiden Werkstückkammern (5, 15) angeordnet sind.

4. Anlage nach Anspruch 1, wobei die beiden Kammern übereinander angeordnet sind, **dadurch gekennzeichnet**, daß das Schieberventil (10) den Boden der ersten Werkstückkammer (5) bildet.

## Claims

1. Installation for electron-beam welding of workpieces, having an electron-beam generator (2) and at least two workpiece chambers (5, 15), which are connected to one another by a slide valve (10) in the region of the beam direction (I) of the electron-beam generator (2) and can be evacuated by means of a vacuum pump (7, 8), whereby a first chamber and a second chamber of the workpiece chambers (5, 15) have distinctly different volumes, characterized by the following features:
 – the first chamber (5) with a small volume is attached to the electron-beam generator (2), which chamber (5) is followed by the second chamber (15) with a large volume,
 – the vacuum pump (7, 8) is only coupled to the first chamber (5) with a small volume,
 – both chambers (5, 15) have separate access doors (6, 16) so that they can be loaded with workpieces independently of one another,
whereby of the workpiece chambers the first chamber (5) with a small volume serves to rapidly process relatively small workpieces and the second chamber (15) with a large volume serves to process relatively large workpieces.

2. Installation according to claim 1, characterized in that the ratio of the volumes of the two workpiece chambers (5, 15) lies between 5 and 1000, and is preferably about 100.

3. Installation according to claim 1, characterized in that the access doors (6, 16) are arranged at different sides of the two workpiece chambers (5, 15).

4. Installation according to claim 1, whereby the two chambers are arranged on top of one another, characterized in that the slide valve (10) forms the floor of the first workpiece chamber (5).

## Revendications

1. Installation de soudage de pièces par bombardement électronique, comprenant un canon à électrons (2) et au moins deux chambres à pièces à traiter (5,15), qui communiquent entre elles par une soupape à coulisse à dans la région de la direction du faisceau (1) du canon à électrons (2) et qui peuvent être mises sous vide par une pompe à vide (7,8), une première chambre et une seconde chambre, parmi les chambres à pièces à traiter (5,15), ayant des volumes nettement différents, remarquable par les caractéristiques suivantes :
 – la première chambre (5) de petit volume, à laquelle fait suivre la seconde chambre (15) de grand volume, se raccorde au canon à électrons (2);
 – la pompe à vide (7,8) n'est reliée qu'à la première chambre (5) de petit volume,
 – les deux chambres (5,15) ont des portes d'accès (6,16) distinctes de manière à pouvoir être chargées en pièces à traiter, indépendamment l'une de l'autre,
la réalisation étant telle que parmi les chambres à pièces à traiter, la première chambre (5) de petit volume sert à traiter rapidement des pièces relativement petites alors que la seconde chambre (15) de grand volume sert à traiter des pièces relativement grandes.

2. Installation suivant la revendication 1, caractérisée en ce que le rapport des volumes des deux chambres à pièces à traiter (5,15) est compris entre 5 et 1000, et de préférence, est de 100 environ.

3. Installation suivant la revendication 1, caractérisée en ce que les portes d'accès (6,16) sont disposées sur des côtés différents des deux chambres à pièces à traiter (5,15).

4. Installation selon la revendication 3, dans laquelle les deux chambres sont superposées, caractérisée par le fait que la soupape à coulisse (10) constitue le fond de la première chambre (5) à pièces à traiter.

FIG 1

FIG 2